# EUROPEAN PATENT SPECIFICATION

(11) **EP 3 623 450 B1**
(45) Date of publication and mention of the grant of the patent: **26.04.2023**
(21) Application number: 19193851.3
(22) Date of filing: 15.05.2012
(51) Int. Cl.: C09K 11/85, C09K 11/61

(54) **APPARATUS COMPRISING A SCINTILLATOR**
VORRICHTUNG ENTHALTEND EINEN SZINTILLATOR
APPAREIL COMPRENTANT UN SCINTILLATEUR

(30) Priority: 22.09.2011 FR 1158467; 28.09.2011 US 201161540326 P; 16.11.2011 WO PCT/IB2011/003028
(43) Date of publication of application: 18.03.2020
(62) Divisional of application: 16166858.7
(73) Proprietor: SAINT-GOBAIN CRISTAUX & DETECTEURS, 92400 Courbevoie (FR)
(72) Inventor: Blahuta, Samuel, 25000 Besancon (FR); Ouspenski, Vladimir, 77140 Saint-Pierre-lès-Nemours (FR)
(74) Representative: Zimmermann & Partner Patentanwälte mbB

(56) References cited:
- POTDEVIN A ET AL: "Structural, morphological and scintillation properties of Ce-doped Y3Al5O12 powders and films elaborated by the sol-gel process", MATERIALS CHEMISTRY AND PHYSICS, ELSEVIER SA, SWITZERLAND, TAIWAN, REPUBLIC OF CHINA, vol. 130, no. 1, 3 August 2011 (2011-08-03), pages 500-506, XP028389166, ISSN: 0254-0584, DOI: 10.1016/J.MATCHEMPHYS.2011.07.019 [retrieved on 2011-07-13]
- HE ET AL: "Growth and optical properties of YBa3B9O18:Ce crystals", JOURNAL OF CRYSTAL GROWTH, ELSEVIER, AMSTERDAM, NL, vol. 307, no. 2, 15 September 2007 (2007-09-15), pages 427-431, XP022497992, ISSN: 0022-0248, DOI: 10.1016/J.JCRYSGRO.2007.06.022
- FRIEDRICH S ET AL: "A 36-Pixel Tunnel Junction Soft X-Ray Spectrometer for Scintillator Material Science", IEEE TRANSACTIONS ON APPLIED SUPERCONDUCTIVITY, IEEE SERVICE CENTER, LOS ALAMITOS, CA, US, vol. 17, no. 2, 1 June 2007 (2007-06-01), pages 351-354, XP011188191, ISSN: 1051-8223, DOI: 10.1109/TASC.2007.898725

## Description

### Field of the Disclosure

The present disclosure is directed to an apparatus comprising a scintillation compound including rare earth elements.

### Related Art

Scintillators can be used for medical imaging and for well logging in the oil and gas industry as well as for the environment monitoring, security applications, and for nuclear physics analysis and applications. Scintillators include scintillation compounds that include rare earth elements, wherein the rare earth element can be a dopant or as a principal constituent within the compound. Further improvement of scintillation compounds is desired.
Potdevin et al., Structural, morphological and scintillation properties of Ce doped Y3Al5O12powders and films elaborated by the sol-gel process, Materials Chemistry and Physics, Elsevier SA, Switzerland, Taiwan, republic of China, Vol. 130, No. 1, 3 August 2011, pages 500 to 506, describe luminescent Ce3+ doped and Ce3+/Tb3+-codoped Y3Al5O12 powders and spray-coated films that have been elaborated by the sol-gel technique. Their purity has been assessed by X-ray diffraction whereby X-ray Absorption Spectroscopy has evidenced the partial oxidation of Ce3+ into Ce4+ in samples containing or not Tb3+. Film thicknesses have been determined by profilometry. Powder and film morphology has been studied using Scanning Electron and Transmission Electron Microscopies, evidencing nanostructured well-defined phosphors. Scintillation properties of both kinds of samples have been investigated upon X-ray radiation and optimal cerium concentration has been determined for crystallized powders. Substitution of one part of yttrium ions by terbium ions in Y3Al5O12:Ce samples has entailed a significant enhancement of scintillation efficiency for both powders and films. These improvements are discussed regarding in particular the changes in the X-ray absorption by photoelectric effect related to the matrix modification. In addition to this enhancement, emission maximum of co-doped samples is red-shifted to 544 nm that matches more suitably with the optic photon detectors used in X-ray imagining.
From M. He et al., Growth and optical properties of YBa3B9O18:Ce crystals, Journal of Crystal Growth, Elsevier, Amsterdam, NL, Vol. 307, No. 2, 15 September 2007, pages 427 to 431, YBa3B9O18:Ce scintillation crystals with a size up to 25 × 12 × 5 mm³ grown by the Czochralski method are known. The X-ray excited luminescence (XEL) spectrum of YBa3B9O18:Ce crystal showed a strong emission at 400 nm similar to a pure YBa3B9O18 crystal. A strong emission shifted to 385 nm and an additional emission at 325 nm was observed due to Ce3+ after annealing the crystal in N2. A new luminescence at 948 nm appeared under the excitation of a 532 nm laser. The refractive indices of the crystal measured by a prism method showed that the crystal is a negative uniaxial crystal. The birefringence is 0.12 in the visible light region, which is comparable to that of a β-BaB2O4 crystal. The refractive indices and transmittance both support that the crystal is strongly anisotropic. The large birefringence and luminescent properties make YBa3B9O18:Ce an attractive optical crystal.
S. Friedrich et al., A 36-Pixel Tunnel Junction Soft X-Ray Spectrometer for Scintillator Material Science, IEEE Transactions on Applied Superconductivity, IEEE Service Center, Los Alamitos, CA, US, Vol. 17, No. 2, 1 June 2007, pages 351 to 354, disclose a 36-pixel superconducting tunnel junction (STJ) spectrometer for high resolution soft X-ray spectroscopy at the synchrotron. It has an energy resolution between ~ 10 and ~ 20 eV FWHM for X-ray energies below ~ 1 keV, and can be operated at maximum total count rates of ~ 10 counts/s. For increased sensitivity, the detector cold finger was modified so that the array subtends a solid angle of Ω/4π ~ 0.1 %. The spectrometer is used at the Advanced Light Source synchrotron for speciation measurements of dilute samples by fluorescence-detected X-ray absorption spectroscopy. Measurements of the oxidation state of dilute cerium activators in scintillator materials are presented, the Ce3+/Ce4+ ratio is determined, and the sensitivity of the instrument for quantitative speciation measurements is discussed.

### Brief Description of the Drawings

Embodiments are illustrated by way of example and are not limited in the accompanying figures.
FIG. 1 includes an illustration of an apparatus including a scintillator having a scintillation compound in accordance with an embodiment.
FIG. 2 includes an absorbance spectrum for a sample that is annealed and another sample that is not annealed.
FIG. 3 includes plots thermoluminescence intensity for a sample that is annealed and another sample that is not annealed.

Skilled artisans appreciate that elements in the figures are illustrated for simplicity and clarity and have not necessarily been drawn to scale. For example, the dimensions of some of the elements in the figures may be exaggerated relative to other elements to help to improve understanding of embodiments of the invention.

### Detailed Description

The following description in combination with the figures is provided to assist in understanding the teachings disclosed herein. The following discussion will focus on specific implementations and embodiments of the teachings. This focus is provided to assist in describing the teachings and should not be interpreted as a limitation on the scope or applicability of the teachings.

Before addressing details of embodiments described below, some terms are defined or clarified. Group numbers corresponding to columns within the Periodic Table of the Elements use the "New Notation" convention as seen in the CRC Handbook of Chemistry and Physics, 81st Edition (2000).

As used in this specification, color space is expressed in terms of L^{∗}, a^{∗}, and b^{∗} coordinates as specified by the Commission Internationale de l'eclairage ("CIE") 1976. The three coordinates represent the lightness of the color (L* = 0 yields black and L* = 100 indicates diffuse white; specular white may be higher), its position between red/magenta and green (a*, negative values indicate green while positive values indicate magenta) and its position between yellow and blue (b*, negative values indicate blue and positive values indicate yellow).

The letter "M," when referring to a particular element within a compound, is intended to mean a metal element. For example, M²⁺ is used to represent a divalent metal. M³⁺ is used to represent a trivalent metal, which in an embodiment, may be a rare earth element, and in another embodiment, may be a trivalent metal other than a rare earth element, such as Al, Ga, Sc, In, or the like.

The term "principal constituent," when referring to a particular element within a compound, is intended to that the element is present as part of the molecular formula for the compound, as opposed to a dopant. A dopant within a compound is typically present at a concentration no greater than 5% atomic. As an example, Ce-doped LaBr₃ (LaBr₃:Ce) includes La and Br as principal constituents, and Ce as a dopant and not a principal constituent.

The term "rare earth" or "rare earth element" is intended to mean Y, La, and the Lanthanides (Ce to Lu) in the Periodic Table of the Elements. In chemical formulas, a rare earth element can be represented by "RE." Rare earth elements are in a trivalent state unless explicitly noted otherwise. Thus, RE (without a valance state designation) and RE³⁺ can be used interchangeably.

As used herein, the terms "comprises," "comprising," "includes," "including, " "has," "having," or any other variation thereof, are intended to cover a non-exclusive inclusion. For example, a process, method, article, or apparatus that comprises a list of features is not necessarily limited only to those features but may include other features not expressly listed or inherent to such process, method, article, or apparatus. Further, unless expressly stated to the contrary, "or" refers to an inclusive-or and not to an exclusive-or. For example, a condition A or B is satisfied by any one of the following: A is true (or present) and B is false (or not present), A is false (or not present) and B is true (or present), and both A and B are true (or present).

The use of "a" or "an" is employed to describe elements and components described herein. This is done merely for convenience and to give a general sense of the scope of the invention. This description should be read to include one or at least one and the singular also includes the plural, or vice versa, unless it is clear that it is meant otherwise.

Unless otherwise defined, all technical and scientific terms used herein have the same meaning as commonly understood by one of ordinary skill in the art to which this invention belongs. The materials, methods, and examples are illustrative only and not intended to be limiting. To the extent not described herein, many details regarding specific materials and processing acts are conventional and may be found in textbooks and other sources within the scintillation and radiation detection arts.

A scintillator can include a scintillation compound that includes a rare earth element. The rare earth element may be present in the scintillation compound as a principal constituent or as a dopant. In a particular scintillation compound, a particular rare earth element can be a constituent, and a different rare earth element can be a dopant. For example, Cs₂LiLuCl₆:Ce includes Lu as a principal constituent and Ce as a dopant. When present as a dopant, the rare earth element may be present within a scintillation compound at a concentration of at least approximately 1000 ppm atomic or at least approximately 5000 ppm atomic in an embodiment, and in another embodiment, may be no greater than approximately 200,000 ppm atomic or no greater than approximately 100,000 ppm atomic.

The rare earth elements can be in a trivalent state. Some of the rare earth elements may be in a tetravalent state, such as Ce, Pr, and Tb, and other rare earth elements can include a divalent state, such as Nd, Sm, Eu, Dy, Tm, and Yb. Such elements may be useful as part of the scintillation mechanism for the scintillation compound. By having a significant amount of a rare earth element in a divalent or tetravalent state, a step in the scintillation process may be obviated.

Too much of the rare earth element in the divalent or tetravalent state may cause electronic charge imbalance and may potentially cause electron or hole traps or other undesired affects to occur. Visible evidence of the electronic charge imbalance may be observed as a change in the color of the crystal. A scintillation compound that may be substantially clear may become more yellow or orange upon visual inspection. In order to maintain electronic charge balance, another element with a different valance state can be present to help keep the overall charge in the scintillation compound balanced. In theory, all of a principal constituent may be replaced by a rare earth element in a divalent, trivalent, or a tetravalent state and another element in a monovalent, divalent, or tetravalent state.

Although not required, such other element may have only one valance state to better allow the rare earth metal element to remain in its desired valence state. For example, the Group 2 elements and Zn are in a divalent state and do not have a monovalent or trivalent state. Unlike the Group 2 elements and Zn, other metal elements have more than one valence state, such as Cu, Ti, Fe, and many of the rare earth elements. While such other metal elements are not excluded, their presence may cause an undesired reduction-oxidation (redox) reaction.

Ce⁴⁺ + Fe²⁺ ↔ Ce³⁺ + Fe³⁺

In the equation above, Ce⁴⁺ may be desired but the redox reaction may lower the concentration of Ce⁴⁺ in the scintillation compound and such lower concentration may be undesired.

Scintillation compounds as described using the concepts herein may have a high light output, lower energy resolution, lower afterglow, better proportionality, shorter decay time or any combination thereof may be achieved, as compared to a corresponding scintillation compound with rare earth element(s) only in a trivalent state and without other elements that are added to affect the electronic charge.

### 1. Replacement of a M³⁺ principal constituent or dopant with RE⁴⁺ and M²⁺

A metal element in a trivalent state (generally noted as M³⁺), which may or may not include a rare earth element in a trivalent state, can be principal constituent or dopant in a scintillation compound and be replaced by a rare earth element in a tetravalent state (RE⁴⁺) and an element in a divalent state (M²⁺), i.e. a Group 2 element (alkaline earth metals), Zn, or any combination thereof. Lu₃Al₅O₁₂:Ce is a scintillation compound and has some of Lu, Al, or Ce replaced by a combination of RE⁴⁺ and M²⁺. In a non-limiting example, the scintillation compound can be represented by Lu_{(3-x-y})RE⁴⁺ₓCa_{y}Al₅O₁₂. RE⁴⁺ can represent a single rare earth element or a combination of rare earth elements in the tetravalent state. RE⁴⁺ is Ce⁴⁺, Pr⁴⁺, Tb⁴⁺, or a combination thereof. Ca may partly or completely be replaced by another Group 2 element, such as Mg, Ba, or Sr, or Zn.

Values for x and y are selected such that RE⁴⁺ is at least 10 ppm atomic, at least approximately 11 ppm atomic, at least approximately 20 ppm atomic, at least approximately 50 ppm atomic, at least approximately 60 ppm atomic, at least approximately 110 ppm atomic, at least approximately 150 ppm atomic, or at least approximately 200 ppm atomic of the scintillation compound. In a particular embodiment, RE⁴⁺ may be at least approximately 20 ppm atomic as the benefit of using the dopant(s) may be significant, and in another particular embodiment, RE⁴⁺ may be at least approximately 110 ppm atomic in particular compounds that use a higher concentration of an activator. In another embodiment, values for x and y may be selected such that the rare earth element in the tetravalent state may be no greater than approximately 5% atomic, no greater than approximately 5000 ppm atomic, no greater than approximately 2000 ppm atomic, no greater than approximately 1500 ppm atomic, no greater than approximately 900 ppm atomic, no greater than approximately 800 ppm atomic, no greater than approximately 700 ppm atomic, no greater than approximately 600 ppm atomic, or no greater than approximately 500 ppm atomic of the scintillation compound. In a particular embodiment, RE⁴⁺ may be no greater than approximately 5000 ppm atomic as a separate phase within the scintillation compound, and in another particular embodiment, RE⁴⁺ may be no greater than approximately 900 ppm atomic due to the segregation coefficient of a particular scintillation compound may make incorporation of higher amounts more difficult. In still another particular embodiment, RE⁴⁺ may be no greater than approximately 500 ppm atomic, in particular compounds do not need a relatively high concentration of an activator.
In an embodiment, values for x and y may be selected such that M²⁺, or each of RE⁴⁺ and M²⁺ may be at least approximately 10 ppm atomic, at least approximately 11 ppm atomic, at least approximately 20 ppm atomic, at least approximately 50 ppm atomic, at least approximately 60 ppm atomic, at least approximately 110 ppm atomic, at least approximately 150 ppm atomic, or at least approximately 200 ppm atomic of the scintillation compound. In a particular embodiment, M²⁺, or each of RE⁴⁺ and M²⁺ may be at least approximately 20 ppm atomic as the benefit of using the dopant(s) may be significant, and in another particular embodiment, M²⁺, or each of RE⁴⁺ and M²⁺ may be at least approximately 110 ppm atomic in particular compounds that use a higher concentration of an activator. In another embodiment, values for x and y may be selected such that the rare earth element in the tetravalent state, the element in the divalent state, or each of both may be no greater than approximately 5% atomic, no greater than approximately 5000 ppm atomic, no greater than approximately 2000 ppm atomic, no greater than approximately 1500 ppm atomic, no greater than approximately 900 ppm atomic, no greater than approximately 800 ppm atomic, no greater than approximately 700 ppm atomic, no greater than approximately 600 ppm atomic, or no greater than approximately 500 ppm atomic of the scintillation compound. In a particular embodiment, M²⁺, or each of RE⁴⁺ and M²⁺ may be no greater than approximately 5000 ppm atomic as a separate phase within the scintillation compound, and in another particular embodiment, M²⁺, or each of RE⁴⁺ and M²⁺ may be no greater than approximately 900 ppm atomic due to the segregation coefficient of a particular scintillation compound may make incorporation of higher amounts more difficult. In still another particular embodiment, RE⁴⁺, M²⁺, or each of both may be no greater than approximately 500 ppm atomic, in particular compounds do not need a relatively high concentration of an activator.

RE⁴⁺ and M²⁺ may be added in equal atomic amounts; however, equal amounts of RE⁴⁺ and M²⁺ are not required. In a further embodiment, on a relative basis, a ratio of RE⁴⁺:M²⁺ is at least approximately 1:90, at least approximately 1:50, at least approximately 1:20, at least approximately 1:9, at least approximately 1:5, at least approximately 1:3, at least approximately 1:2, or at least approximately 1:1.5, or at least approximately 1:1.1. In a still further embodiment, on a relative basis, a ratio of RE⁴⁺:M²⁺ is no greater than approximately 90:1, no greater than approximately 50:1, no greater than approximately 20:1, no greater than approximately 9:1, no greater than approximately 5:1, no greater than approximately 3:1, no greater than approximately 2:1, or at least approximately 1.5:1, or no greater than approximately 1.1:1. In a particular embodiment, the ratio of RE⁴⁺:M²⁺ may be in a range of approximately 1:3 to approximately 3:1 to maintain an acceptable charge balance within the scintillation compound. In a more particular embodiment, the ratio of RE⁴⁺:M²⁺ may be in a range of approximately 1:1.5 to approximately 1.5:1 to provide even better charge balance within the scintillation compound.

The scintillation compound can be in the form of a single crystal or as a polycrystalline material. The scintillation compound in the form of a single crystal may be formed using a fusion zone technique, a Czochralski, a Bridgman, or an edge feed growth (EFG) technique. With the fusion zone technique, a solid material can be processed such that a crystal seed is in contact with one end of the solid, and a heat source causes a local region (portion of the solid) to become molten near the crystal. The temperature of the ambient near the molten material be at a temperature of at least approximately 1600°C or least 1800°C, and may be no greater than approximately 2200°C, or no greater than approximately 2100°C.

As the heat source moves away from the crystal, the molten portion becomes monocrystalline, and a new local region farther from the seed crystal becomes molten. The process is continued until the rest of the solid has become crystallized. The solid can be oriented in a vertical or horizontal direction during the process. The particular crystal growth methods as melting zone and floating zone are belonging to general notation known as fusion zone technique. The fusion zone technique may be able to incorporate a higher level of dopant than the Czochralski or Bridgman growth techniques, as volatilization or segregation of species may limit the ability of how much dopant will be in the crystal. The scintillation compound can be in the form of a polycrystalline material. Such materials can be formed using calcining, pressing, sintering, or any combination thereof. In an embodiment, a polycrystalline powder (obtained by hydrothermal method or by precipitation in alkaline solution or by vapor phase) is used, the powder possibly being compacted with or without the use of a binder or thermally densified or assembled by a sol-gel method. In a further embodiment, the compound can be a monocrystalline or polycrystalline fiber (obtained by micro-pulling down or by EFG), or thin film (obtained by CVD), or a polycrystalline glass-ceramic. The scintillating compound may be incorporated in a host material that may be transparent, such as a glass or a plastic or a liquid or a crystal. The host material may be used to excite indirectly the scintillating compound.

If needed or desired, an anneal may be performed after forming the scintillation compound. The anneal may be performed using any of the ambients previously described. The temperature for the anneal may be at least approximately 1100°C or at least approximately 1200°C, and may be at no greater than approximately 1600°C or no greater than approximately 1500°C.

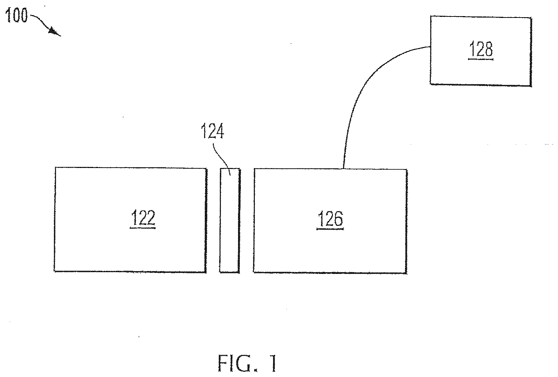

The scintillation compound can be used to form a scintillator or other scintillation device useful in many apparatuses. FIG. 1 illustrates an embodiment of an apparatus 100 that includes a scintillator 122, a light guide 124, a photosensor 126, and control unit 128. The scintillator 122 can include a scintillation compound as previously described. The light guide 124 is substantially transparent to scintillating light emitted by the scintillator 122. The photosensor 126 can generate electrons in response to receiving scintillating light from the scintillator 122. The photosensor 126 can be a photomultiplier, a photodiode, an avalanche diode, or the like. The scintillator 122, the light guide 124, and the photosensor 126 are optically coupled together. Although the scintillator 122, the light guide 124, and the photosensor 126 are illustrated as being spaced apart, the light guide 124 may directly contact the scintillator 122 or the photosensor 126. In another embodiment, a coupling material, such as a substantially clear silicone gel may be used to couple the scintillator 122, the light guide 124, and the photosensor 126 together. The scintillator 122, the light guide 124, and the photosensor 126 may be located inside one or more housings so that ambient light or other undesired radiation does not reach the photosensor 126. The control unit 128 is electrically coupled to the photosensor 126. During normal operation, radiation can be captured by the scintillator 122, and the scintillator 122 emits scintillating light in response to receiving the targeted radiation. The scintillating light is received by the photosensor 126 that generates an electronic signal that is transmitted to the control unit 128. The control unit 128 includes hardware, firmware, or software that is configured so that the control unit 128 can generate information regarding the targeted radiation, such as the type of radiation (x-rays, gamma-rays, beta particles, and the like), intensity of the radiation, location of where the radiation was captured or where the radiation originated, or any combination thereof.

The apparatus can be a radiation detection apparatus, such as a medical imaging apparatus, a well logging apparatus, a security inspection apparatus, or the like. In a particular embodiment, the radiation detection system can be used for gamma ray analysis, such as a Single Positron Emission Computer Tomography (SPECT) or Positron Emission Tomography (PET) analysis. In another embodiment, the scintillation compound may be used for other applications outside of radiation detection. For example, the apparatus can include a luminescence emitter, especially monochromatic, for UV spectra, visible and IR, as for a wavelength conversion system, for example a laser device. In such a device, a control unit can be coupled to the scintillator 122, and the light guide 124 and photosensor 126 can be replaced by a lens or another suitable optical feature. Yet another apparatus that can use the scintillation compound can include an optical data storage device.

Scintillation compounds as described in accordance with the concepts described herein have unusually good light output, energy resolution, linearity, decay time, and afterglow properties. Linearity refers to how well a scintillation crystal approaches perfect linear proportionality between radiation energy and light output. The linearity can be measured as a departure from perfect linearity. A scintillation crystal having perfect linearity would always create the same number of photons per unit energy absorbed, regardless of the energy of the radiation. Thus, its departure from perfect linearity is zero. In an embodiment, a scintillation compound can have an afterglow of less than 200 ppm after 100 ms relative to the intensity measured during an x-ray irradiation. In a particular embodiment, an improvement with less afterglow may be accompanied by a reduction in the decay time and an increase in light yield. The presence of a rare earth element in a divalent or tetravalent state with an electronic charge compensating material can allow a scintillation compound to maintain electronic charge balance, yet still achieve benefits of having the rare earth element in the divalent or tetravalent state.

A non-limiting embodiment is described to illustrate better the current understanding of how concepts described herein are applicable to scintillation compounds. A rare earth aluminum garnet, such as LuAG, can be formed and include at least some rare earth element in the tetravalent state, Ce⁴⁺ within the finished scintillation compound. If too much Ce⁴⁺ is added without any electronic charge compensating species, the LuAG compound may have too many oxygen vacancies that can act as electron traps. When radiation is captured, electrons within the LuAG compound become excited. Some electrons will return to a lower energy state and emit scintillating light, which is desired; however, other electrons become trapped and do not emit light when trapped. The electrons may become untrapped due to temperature and emit light referred to as thermoluminescence. Thus, the electron traps are problematic because electrons that become trapped will not emit scintillating light at the time when electrons outside the traps emitting scintillating light, and electrons released from the traps will emit light but it will be at a time after the scintillating light from nontrapped electrons was emitted. By maintaining better electronic charge balance, oxygen vacancies may be less likely to trap electrons. Continuing with the prior example, a Group 2 element, such as Ca, Mg, Sr, Zn, or the like, can be incorporated into the scintillation compound. The Group 2 element or Zn is in a divalent state and does not or is not readily oxidized. Thus, the LuAG compound can be formed in an oxidizing ambient sufficient to achieve a desired concentration of Ce⁴⁺ without a significant risk of forming oxygen vacancies while still maintaining better electronic charge balance at least in part due to the presence of the Group 2 element or Zn that is not readily oxidized. The addition of a rare earth element in a tetravalent state can obviate a step in the scintillation mechanism in many scintillation compounds. The modified scintillation mechanism consists of the interaction of cerium in 4+ state with high energy X-ray or γ-photons and converting Ce⁴⁺ directly into excited (3+)* state together with generating of a hole. Divalent elements are participating in the scintillation mechanism having a particular role of hole traps.

Ideally, a pair of rare earth metal atoms in a trivalent state is replaced by a rare earth atom in a tetravalent state and a metal atom in a divalent state, such as a Group 2 element, Zn, or any combination thereof. In practice, with respect to replacing rare earth metal atoms in a trivalent state, the ratio of rare earth atoms in a tetravalent state to metal atoms in a divalent state does not need to be 1:1, since not all the dopant atoms are participating in scintillation mechanism and thus, some electronic charge imbalance does not deviate from the concepts described herein. Better performance may result as the ratio is kept closer to 1:1.

The presence of Ce⁴⁺ can be determined from crystal samples polished on their two parallel sides, through which sides the spectrophotometic operation was carried out. The distance between these parallel sides (thickness of the sample) may be from 0.2 to 50 mm. In a particular embodiment, the samples are nominally 1 mm thick. A Cary 6000i-brand spectrophotometer measuring in the UV and in the visible, marketed by Varian, now part of Agilent Technologies, Inc., under the trade name Cary 6000i, and having a resolution of less than or equal to 1 nm, may be used. The direct transmission mode was used on the samples. Samples were measured using an interval of 0.5 nm, an acquisition time of 0.1 s per point and an SBW (spectral bandwidth) of 2 nm. Absorbance (also called the optical density) of each sample is measured as a function of wavelength between 190 nm and 600 nm. Background noise is subtracted before determining a ratio of the absorbance at 357 nm to the absorbance at 280 nm, referenced A₃₅₇/A₂₈₀.

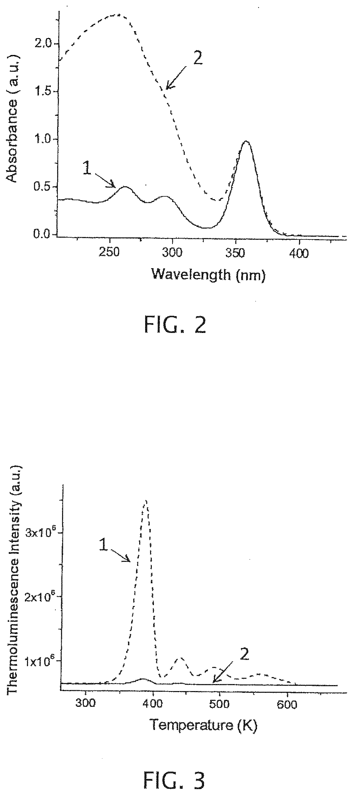

FIG. 2 includes the absorbance spectra in the case of sample 2 (referenced "2" in the figure) after an air annealing (according to an embodiment) and in the case of sample 1 (referenced "1" in the figure), a reference sample, representative of the prior art, that is not annealed. In the case of sample 2, after an air annealing, an absorbance maximum is observed at 250 nm, the origin of which is Ce⁴⁺.

FIG. 3 compares the thermoluminescence intensity of a compound in the case of sample 2 (referenced "2") after an air annealing and in the case of sample 1 (unannealed reference sample, referenced "1") representative of the prior art. In the case of the sample 2, a very substantial drop in the thermoluminescence intensity, especially around 300 K, is noticed, and thus, afterglow is reduced.

References have been published that disclose the addition of dopants to improve the performance of scintillator crystals. US 2011/0204240 teaches that Ca is added so that Ce⁴⁺ forms Ce³⁺ in cerium-doped lutetium yttrium orthosilicate (LYSO:Ce). Clearly, RE⁴⁺ has been undesired in the prior art. Unlike the teachings of the prior art, a rare earth element can be intentionally kept in a tetravalent state and achieve the benefits of such state while still maintaining electronic charge balance.

Samples for color change evaluation may be used as formed, have a surface polished, fractured roughed, or have another suitable sample preparation performed. White light may be directed such that it is directed perpendicular to the surface, at an angle other than perpendicular to the surface, or from a plurality of light sources oriented at different angles with respect to the surface. One or more different techniques may be used to determine color change.

In an embodiment, CIE 1976 color space coordinates, L*, a*, and b* can be used. The CIE 1976 color space coordinates may be obtained using a Cary 6000i-brand spectrophotometer from Varian, now part of Agilent Technologies, Inc. The scintillation compound reflects substantially white light at color space coordinates of L1^{∗}, a1^{∗}, b1^{∗} that correspond to CIE 1976 color space coordinates L^{∗}, a^{∗}, and b^{∗} for the scintillation compound. The corresponding base compound reflects substantially white light at color space coordinates of L2^{∗}, a2^{∗}, b2^{∗} that correspond to CIE 1976 color space coordinates L*, a*, and b* for the corresponding base compound. The color difference between the scintillation compound and the base compound may be such that |a1^{∗}-a2^{∗}| is no greater than approximately 9, and |b1^{∗}-b2^{∗}| is no greater than approximately 9. In another embodiment, |a1^{∗}-a2^{∗}| is no greater than approximately 5, is no greater than approximately 3, is no greater than approximately 2, is no greater than approximately 1.5, is no greater than approximately 0.9, is no greater than approximately 0.5, or is no greater than approximately 0.2, is no greater than approximately 0.09, no greater than approximately 0.05, or no greater than approximately 0.01, and |b1^{∗}-b2^{∗}| is no greater than approximately 5, is no greater than approximately 3, is no greater than approximately 2, is no greater than approximately 1.5, is no greater than approximately 0.9, is no greater than approximately 0.5, or is no greater than approximately 0.2, is no greater than approximately 0.09, no greater than approximately 0.05, or no greater than approximately 0.01. In a further embodiment, |L1^{∗}-L2^{∗}| is no greater than approximately 9, no greater than approximately 5, is no greater than approximately 3, is no greater than approximately 2, is no greater than approximately 1.5, is no greater than approximately 0.9, is no greater than approximately 0.5, or is no greater than approximately 0.2.

As an alternative to color space coordinates, the wavelength of reflected light may be used. The scintillation compound reflects substantially white light at a first wavelength, and its corresponding base compound reflects substantially white light at a second wavelength. In an embodiment, first and second wavelengths are no greater than approximately 50 nm from each other, no greater than approximately 30 nm, no greater than approximately 20 nm, no greater than approximately 15 nm, no greater than approximately 9 nm, no greater than approximately 5 nm, no greater than approximately 2 nm from each other.

In still another embodiment, a particular spectrum of wavelengths may be used. In one example, a scintillation compound is colorless when sufficiently electronic charge balanced, and a similar scintillator compound has a yellow color if not sufficiently electronic charge balanced. The intensity of the reflected light at wavelengths from 400 nm to 700 nm for the scintillator compounds may be compared. A color change may be determined if the data significantly differ. Alternatively, only blue light (for example, light having an emission maximum at a wavelength in a range of 400 nm to 450 nm) may be used to illuminate the scintillation compounds. The scintillation compound that is colorless may reflect substantially more of the blue light as compared to the scintillation compound that has the yellow color.

In another example, a different scintillation compound has a yellow color when sufficiently electronic charge balanced, and yet another similar scintillator compound has a green color if not sufficiently electronic charge balanced. The intensity of the reflected light at wavelengths from 400 nm to 700 nm for the scintillator compounds may be compared. An analysis may be performed with different color lights. A first set of data may be obtained when, only green light (for example, light having an emission maximum at a wavelength in a range of 500 nm to 550 nm) is used to illuminate the scintillation compounds. A second set of data may be obtained when, only red light (for example, light having an emission maximum at a wavelength in a range of 650 nm to 700 nm) is used to illuminate the scintillation compounds. The scintillation compound that is yellow may reflect substantially more of the red light and less of the green light as compared to the scintillation compound that has the green color.

Many different aspects and embodiments are possible. Some of those aspects and embodiments are described herein. After reading this specification, skilled artisans will appreciate that those aspects and embodiments are only illustrative and do not limit the scope of the present invention. Additionally, those skilled in the art will understand that some embodiments that include analog circuits can be similarly implemented using digital circuits, and vice versa.

### COMPARATIVE EXAMPLES

The concepts described herein will be further described in the comparative Examples. The comparative Examples demonstrate performance of scintillation crystals of different compositions. Numerical values as disclosed in this Examples section may be approximated or rounded off for convenience.

The comparative examples below help to illustrate potential improvements with light yield (LY) and energy resolution for some exemplary compounds. All sample sizes are in mm, and energy resolution is based on full-width, half-maximum (FWHM) data. Content levels as listed in the tables below are in ppm atomic. Further, in the examples that are doped with Pr, the Pr-doped materials include some Ce as an impurity; however, the amount of Ce is not present in an amount that significantly affects the scintillation properties.

### Example of LaCl₃ doped with cerium:

| 10x10x10mm cubes | **Ce⁴⁺ Content XANES** | LY (Photons/MeV ¹³⁷Cs 662 keV) | Energy resolution |
|---|---|---|---|
| LaCl₃:Ce | 50 ppm | 48000 | 4.7% |
| LaCl₃:Ce,Ca²⁺ | 1250 ppm | 50500 | 4.5% |
| LaCl₃:Ce,Mg²⁺ | 1000 ppm | 50000 | 4.6% |
| LaCl₃:Ce,Ba²⁺ | 600 ppm | 49000 | 4.5% |
| LaCl₃:Ce,Sr²⁺ | 600 ppm | 49000 | 4.45% |

### Examples with CLYC doped cerium or praseodymium

| 10x10x10mm cubes | **RE⁴⁺ content XANES** | LY (Photons/MeV ¹³⁷Cs 662 keV) | Energy resolution |
|---|---|---|---|
| Cs₂LiYCl₆:Ce | not detectable | 21000 | 6.6% |
| Cs₂LiYCl₆:Ce,Ca²⁺ | 1200 ppm | 21000 | 6.2% |
| Cs₂LiYCl₆:Ce,Mg²⁺ | 800 ppm | 21000 | 6.1% |
| Cs₂LiYCl₆:Ce,Sr²⁺ | 750 ppm | 21000 | 6.2% |
| Cs₂LiYCl₆:Ce,Ba²⁺ | 500 ppm | 21000 | 6.3% |
| Cs₂LiYCl₆:Pr | not detectable | 8500 | 8.4% |
| Cs₂LiYCl₆:Pr,Ca²⁺ | 400 ppm | 9500 | 7.2% |
| Cs₂LiYCl₆:Pr,Mg²⁺ | 350 ppm | 9500 | 6.8% |
| Cs₂LiYCl₆:Pr,Sr²⁺ | 550 ppm | 9500 | 6.7% |
| Cs₂LiYCl₆:Pr:Ce,Ba²⁺ | 600 ppm | 9500 | 6.7% |

### Examples with CLLC doped cerium or praseodymium

| 10x10x10mm cubes | **RE⁴⁺ content XANES** | LY (Photons/MeV ¹³⁷Cs 662 keV) | Energy resolution |
|---|---|---|---|
| Cs₂LiLaCl₆:Ce | not detectable | 34000 | 3.9% |
| Cs₂LiLaCl₆:Ce,Ca²⁺ | 800 ppm | 34000 | 3.6% |
| Cs₂LiLaCl₆:Ce,Mg²⁺ | 900 ppm | 34000 | 3.6% |
| Cs₂LiLaCl₆:Ce,Ba²⁺ | 600 ppm | 34000 | 3.6% |
| Cs₂LiLaCl₆:Pr | not detectable | 10500 | 8.4% |
| Cs₂LiLaCl₆:Pr,Ca²⁺ | 550 ppm | 10500 | 8.0% |
| Cs₂LiLaCl₆:Pr,Mg²⁺ | 400 ppm | 10500 | 7.8% |
| Cs₂LiLaCl₆:Pr,Ba²⁺ | 500 ppm | 10500 | 7.8% |

### Examples with CLLB doped cerium or praseodymium

| 10x10x10mm cubes | **RE⁴⁺ Content XANES** | LY (Photons/MeV ¹³⁷Cs 662 keV) | Energy resolution |
|---|---|---|---|
| Cs₂LiLaBr₆:Ce | not detectable | 34500 | 5.1% |
| Cs₂LiLaBr₆:Ce,Ca²⁺ | 800 ppm | 36500 | 4.8% |
| Cs₂LiLaBr₆:Ce,Mg²⁺ | 700 ppm | 36000 | 4.8% |
| Cs₂LiLaBr₆:Ce,Ba²⁺ | | | |
| Cs₂LiLaBr₆:Pr | not detectable | 16000 | 6.7% |
| Cs₂LiLaBr₆:Pr,Mg²⁺ | 400 ppm | 16000 | 6.4% |
| Cs₂LiLaBr₆:Pr,Ba²⁺ | 450 ppm | 16000 | 6.5% |
| Cs₂LiLaBr₆:Pr,Ca²⁺ | 500 ppm | 16000 | 6.4% |

### Examples with SrI₂ doped europium

| 2x6x6mm | **RE³⁺ Content XANES** | LY (Photons/MeV ¹³⁷Cs 662 keV) | Energy resolution |
|---|---|---|---|
| SrI₂:2%Eu | not detectable | 98000 | 3.1% |
| SrI₂:2%Eu,Cs¹⁺ | 400 ppm | 98000 | 2.9% |

### Examples with CeBr3

| 2x6x6mm | **RE⁴⁺ Content XANES** | LY (Photons/MeV ¹³⁷Cs 662 keV) | Energy resolution |
|---|---|---|---|
| CeBr₃ | not detectable | 66000 | 3.6% |
| CeBr₃,Ca²⁺ | 800 ppm | 66000 | 3.4% |
| CeBr₃,Mg²⁺ | 700 ppm | 66000 | 3.45% |
| CeBr₃,Sr²⁺ | 900 ppm | 66000 | 3.4% |
| CeBr₃,Ba²⁺ | 650 ppm | 66000 | 3.45% |

### Examples with K₂YF₅ doped praseodymium

| 2x6x6mm | **RE⁴⁺ Content XANES** | LY (Photons/MeV ¹³⁷Cs 662 keV) | Energy resolution |
|---|---|---|---|
| K₂YF₅:Pr | not detectable | 7000 | 8.6% |
| K₂YF₅:Pr,Ca²⁺ | 400 ppm | 7000 | 8.2% |
| K₂YF₅:Pr,Sr²⁺ | 350 ppm | 7000 | 8.2% |
| K₂YF₅:Pr,Mg²⁺ | 400 ppm | 7000 | 8.0% |
| K₂YF₅:Pr,Ba²⁺ | 250 ppm | 7000 | 8.4% |

### Examples with CeCl3 undoped

| 2x6x6mm | **RE⁴⁺ Content XANES** | LY (Photons/MeV ¹³⁷Cs 662 keV) | Energy resolution |
|---|---|---|---|
| CeCl₃ | not detectable | 46000 | 3.5% |
| CeCl₃,Ca²⁺ | 300 ppm | 46000 | 3.4% |
| CeCl₃,Mg²⁺ | 350 ppm | 46000 | 3.4% |
| CeCl₃,Sr²⁺ | 350 ppm | 46000 | 3.3% |
| CeCl₃,Ba²⁺ | 250 ppm | 46000 | 3.45% |

### Examples with CeF₃ lutetium doped

| 2x6x6mm | **RE⁴⁺ Content XANES** | LY (Photons/MeV ¹³⁷Cs 662 keV) | Energy resolution |
|---|---|---|---|
| CeF₃:Lu | not detectable | 8500 | 9.2% |
| CeF₃:Lu,Ca²⁺ | 650 ppm | 8500 | 8.8% |
| CeF₃:Lu,Mg²⁺ | 780 ppm | 8500 | 8.7% |
| CeF₃:Lu,Sr²⁺ | 700 ppm | 8500 | 8.8% |
| CeF₃:Lu,Ba²⁺ | 600 ppm | 8500 | 9.0% |

### Examples with PrBr₃ doped cerium

| 2x6x6mm | **RE⁴⁺ Content XANES** | LY (Photons/MeV ¹³⁷Cs 662 ke V) | Energy resolution |
|---|---|---|---|
| PrBr₃:Ce | not detectable | 17500 | 5.5% |
| PrBr₃:Ce,Ca²⁺ | 400 ppm | 17500 | 5.2% |
| PrBr₃:Ce,Mg²⁺ | 450 ppm | 17500 | 5.35% |
| PrBr₃:Ce,Sr²⁺ | 500 ppm | 17500 | 5.3% |
| PrBr₃:Ce,Ba²⁺ | 400 ppm | 17500 | 5.4% |

The comparative Examples demonstrate a significant improvement of energy resolution (that is lower energy resolution) when a combination of RE⁴⁺ and M²⁺ is within the scintillation compound as compared to a scintillation compound without the RE⁴⁺ and M²⁺. In general, the energy resolution is in a range of approximately 5% to 20% lower for the scintillation compounds with RE⁴⁺ and M²⁺ co-dopants, as compared to the same compound without the co-dopants. For the scintillator compound with the RE³⁺ and M¹⁺ co-dopants, the improvement is significant but not as great as for the RE⁴⁺ and M²⁺ co-dopants. Scintillation is more effective with electrons as compared to holes. Still, the scintillation compound with RE³⁺ and M¹⁺ helps to improve performance.

Note that not all of the activities described above in the general description or the examples are required, that a portion of a specific activity may not be required, and that one or more further activities may be performed in addition to those described. Still further, the order in which activities are listed is not necessarily the order in which they are performed.

Certain features that are, for clarity, described herein in the context of separate embodiments, may also be provided in combination in a single embodiment. Conversely, various features that are, for brevity, described in the context of a single embodiment, may also be provided separately or in any subcombination. Further, reference to values stated in ranges includes each and every value within that range.

Benefits, other advantages, and solutions to problems have been described above with regard to specific embodiments.

The specification and illustrations of the embodiments described herein are intended to provide a general understanding of the structure of the various embodiments. The specification and illustrations are not intended to serve as an exhaustive and comprehensive description of all of the elements and features of apparatus and systems that use the structures or methods described herein. Separate embodiments may also be provided in combination in a single embodiment, and conversely, various features that are, for brevity, described in the context of a single embodiment, may also be provided separately or in any subcombination. Further, reference to values stated in ranges includes each and every value within that range. Many other embodiments may be apparent to skilled artisans only after reading this specification. Other embodiments may be used and derived from the disclosure, such that a structural substitution, logical substitution, or another change may be made without departing from the scope of the disclosure. Accordingly, the disclosure is to be regarded as illustrative rather than restrictive.

## Claims

1. An apparatus comprising:
a scintillation compound, wherein the scintillation compound is represented by Lu_{(3-x-y)}RE⁴⁺ₓM_{y}AlₛO₁₂, in which:
Lu is in a trivalent state, wherein RE⁴⁺ is a rare earth element in a tetravalent state, wherein RE⁴⁺ may be Ce⁴⁺, Pr⁴⁺, Tb⁴⁺, or a combination thereof, and wherein a quantity of RE⁴⁺ in the scintillation compound is at least 10 ppm atomic; and
M represents a group 2 element or Zn, wherein M is in a divalent state.

2. The apparatus of claim 1, wherein M is selected from the group consisting of Ca, Mg, Ba, Sr, and Zn.

3. The apparatus of claim 1, wherein a ratio of RE⁴⁺:M is at least 1:90.

4. The apparatus of claim 1, wherein a ratio of RE⁴⁺:M is at least 1:50.

5. The apparatus of claim 1, wherein a ratio of RE⁴⁺:M is no greater than 90:1.

6. The apparatus of claim 1, wherein RE⁴⁺ is cerium.

7. The apparatus of claim 2, wherein M²⁺ is Ca.

## Patentansprüche

1. Vorrichtung, umfassend:
eine Szintillationsverbindung, wobei die Szintillationsverbindung dargestellt wird durch Lu_{(3-x-y)}RE⁴⁺ₓM_{y}Al₅O₁₂, in der:
Lu sich in einem dreiwertigen Zustand befindet, wobei RE⁴⁺ ein Seltenerdelement in einem vierwertigen Zustand ist, wobei RE⁴⁺ Ce⁴⁺, Pr⁴⁺, Tb⁴⁺ oder eine Kombination davon sein kann und wobei eine Menge von RE⁴⁺ in der Szintillationsverbindung mindestens 10 Atom-ppm beträgt; und
M ein Element der Gruppe 2 oder Zn darstellt, wobei sich M in einem zweiwertigen Zustand befindet.

2. Vorrichtung nach Anspruch 1, wobei M aus der Gruppe ausgewählt ist, bestehend aus Ca, Mg, Ba, Sr und Zn.

3. Vorrichtung nach Anspruch 1, wobei ein Verhältnis von RE⁴⁺:M mindestens 1:90 beträgt.

4. Vorrichtung nach Anspruch 1, wobei ein Verhältnis von RE⁴⁺:M mindestens 1:50 beträgt.

5. Vorrichtung nach Anspruch 1, wobei ein Verhältnis von RE⁴⁺:M nicht größer als 90:1 ist.

6. Vorrichtung nach Anspruch 1, wobei RE⁴⁺ Cer ist.

7. Vorrichtung nach Anspruch 2, wobei M²⁺ Ca ist.

## Revendications

1. Appareil comprenant :
un composé de scintillation, dans lequel le composé de scintillation est représenté par Lu_{(3-x-y)}RE⁴⁺ₓM_{y}Al₅O₁₂, dans lequel :
Lu est dans un état trivalent, dans lequel RE⁴⁺ est un élément de terre rare dans un état tétravalent, dans lequel RE⁴⁺ peut être Ce⁴⁺, Pr⁴⁺, Tb⁴⁺ ou une combinaison de ceux-ci et dans lequel une quantité de RE⁴⁺ dans le composé de scintillation est d'au moins 10 ppm atomique ; et
M représente un élément du groupe 2 ou Zn, dans lequel M est dans un état divalent.

2. Appareil selon la revendication 1, dans lequel M est choisi dans le groupe constitué de Ca, Mg, Ba, Sr et Zn.

3. Appareil selon la revendication 1, dans lequel un rapport RE⁴⁺:M est d'au moins 1:90.

4. Appareil selon la revendication 1, dans lequel un rapport RE⁴⁺:M est d'au moins 1:50.

5. Appareil selon la revendication 1, dans lequel un rapport RE⁴⁺:M n'est pas supérieur à 90:1.

6. Appareil selon la revendication 1, dans lequel RE⁴⁺ est le cérium.

7. Appareil selon la revendication 2, dans lequel M²⁺ est Ca.
